# FASCICULE DE BREVET EUROPEEN

(11) **EP 0 843 418 B1**
(45) Date de publication et mention de la délivrance du brevet: **07.06.2000**
(21) Numéro de dépôt: 97460045.4
(22) Date de dépôt: 10.11.1997
(51) Int. Cl.: H03M 9/00, H03K 3/3562, H04L 7/033

(54) **Dispositif de conversion série/parallèle d'un signal haute fréquence de faible amplitude**
Serie-Parallel-Umwandlungsvorrichtung für Hochfrequenz-/Niedrigamplitude-Signale
Serial-to-Parallel conversion device for a high frequency, low amplitude signal

(30) Priorité: 19.11.1996 FR 9614344
(43) Date de publication de la demande: 20.05.1998
(73) Titulaire: STMicroelectronics S.A., 94250 Gentilly (FR)
(72) Inventeur: Marbot, Roland, 56100 Lorient (FR); Couteaux, Pascal, 56100 Lorient (FR); D'Hoe, Michel, 56100 Lorient (FR); Le Bihan, Jean Claude, 56100 Lorient (FR); Mottini, Francis, 56100 Lorient (FR); Nezamzadeh, Réza, 56100 Lorient (FR); Pierre Duplessix, Anne, 56100 Lorient (FR)
(74) Mandataire: Ballot, Paul

(56) Documents cités:
- EP-A- 0 397 198
- EP-A- 0 472 426
- US-A- 3 961 138
- US-A- 5 003 561
- US-A- 5 170 074
- PROFIT A.: "STRUCTURE ET TECHNOLOGIE DES ORDINATEURS" 1970 , ARMAND COLIN , PARIS XP002033650 * page 431 - page 438; figures 18.28-29 *

## Description

La présente invention concerne un dispositif de conversion d'un signal série reçu sous la forme d'un signal différentiel haute fréquence de faible amplitude en n signaux parallèles. L'invention trouve plus particulièrement son application dans le domaine de la réception de données série.

L'utilisation d'un signal différentiel est particulièrement adaptée pour la transmission de données dans les liaisons série. En effet, les perturbations (distorsions, bruits) qui apparaissent au cours de la transmission du signal, agissent indifféremment sur les deux signaux formant le signal différentiel et par conséquent ne dégradent pas l'information à transmettre qui est la différence entre les deux signaux.

Le dispositif de conversion tel que décrit dans la présente demande permet de convertir un signal différentiel haute fréquence et de faible amplitude représentant un train de bits en n signaux logiques parallèles.

Les dispositifs de conversion connus comportent généralement une entrée différentielle pour recevoir un signal différentiel série de période T. Ce signal est appliqué aux entrées d'un amplificateur différentiel afin de le transposer sur deux niveaux logiques Vdd et Vss. Le signal transformé est ensuite échantillonné par un ensemble de n registres maître/esclave connectés en parallèle sur la sortie de l'amplificateur. La période d'échantillonnage des registres est prise égale à nT et les signaux d'échantillonnage des n registres maître/esclave sont décalés les uns par rapport aux autres d'un intervalle de temps égal à la période T du signal différentiel. Ainsi, à la sortie des n registres maître/esclave, on obtient n échantillons du signal série décalés d'un intervalle de temps T. Par exemple, l'ouvrage intitulé "Structure et Technologie des Ordinateurs", par A. Profit, publié en 1970 chez Armand Colin (Paris), décrit page 436 l'architecture générale d'un convertisseur série/parallèle dont l'entrée est reliée à n bascules synchronisées à l'aide de n signaux d'horloge. En outre, le document EP 472 426 décrit des bascules R-S maître-esclaves en technologie CMOS destinées à des applications rapides.

Par exemple, pour la conversion d'un train de bits reçu à une fréquence de 100KHz en mots de 10 bits, le dispositif de conversion comporte 10 registres maître/esclave qui échantillonnent le train de bits à une fréquence de 10 KHz et les instants d'échantillonnage de ces différents registres sont décalés de 10 µs les uns par rapport aux autres.

Il est également à noter que certains types de dispositifs ne fonctionnent pas de manière satisfaisante lorsque la fréquence du train de bits reçu est élevée, de l'ordre du gigahertz. En effet, à cette fréquence, les amplificateurs différentiels introduisent une instabilité au niveau de la base de temps du signal reçu et par conséquent déplacent les fronts du signal série. Ce phénomène est accentué lorsque le signal différentiel appliqué à l'entrée de l'amplificateur comporte du bruit en mode commun. Il en résulte que les échantillons obtenus à la sortie des registres maître/esclave peuvent dans certains cas ne plus être représentatifs du train de bits de départ.

L'un des buts de l'invention est donc de proposer un dispositif de conversion permettant de s'affranchir de l'utilisation d'un amplificateur différentiel pour transposer le signal différentiel d'entrée sur deux niveaux logiques.

L'invention permettant de ne pas introduire d'instabilité au niveau de la base de temps du signal reçu au moment de l'amplification, elle est particulièrement adaptée pour les dispositifs de conversion comportant des moyens de récupération du signal d'horloge du signal série reçu.

Aussi, l'invention a pour objet un dispositif tel que défini dans la revendication 1.

Par ailleurs, la partie esclave de l'échantillonneur/bloqueur comporte de préférence une troisième porte de connexion connectée d'une part à l'entrée du premier inverseur de la partie maître et d'autre part à l'entrée d'un troisième inverseur, à la sortie d'un quatrième inverseur et à la première sortie de l'échantillonneur/bloqueur, une quatrième porte de connexion connectée d'une part à la sortie du premier inverseur et d'autre part à la sortie du troisième inverseur, à l'entrée du quatrième inverseur, les troisième et quatrième portes de connexion étant commandées par un second couple de signaux de commande issu dudit signal d'horloge appliquée sur l'entrée de commande de l'échantillonneur/bloqueur.

Dans la plupart cas, la conversion du signal série reçu ne se limite pas simplement à une remise à niveau du signal sur deux niveaux logiques et à son échantillonnage: il faut également resynchroniser le signal reçu, c'est-à-dire mettre les fronts des signaux d'échantillonnage en phase avec le signal d'horloge associé au signal reçu.

La technique utilisée pour resynchroniser le signal série reçu de fréquence f consiste à échantillonner le signal à la fréquence 2f. Comme le signal reçu représente un train de bits, chaque bit est ainsi échantillonné deux fois. Le but de cette technique est de repérer les instants de transition entre les bits du signal reçu pour ensuite adapter l'échantillonnage du signal en fonction de ces instants.

D'autres caractéristiques et avantages de l'invention apparaîtront à la lecture de la description détaillée qui suit et qui est faite en référence aux dessins annexés dans lesquels :
- la figure 1 est un mode de réalisation préféré d'un dispositif de conversion selon l'invention; et
- la figure 2 est un schéma d'un échantillonneur/bloqueur selon l'invention.

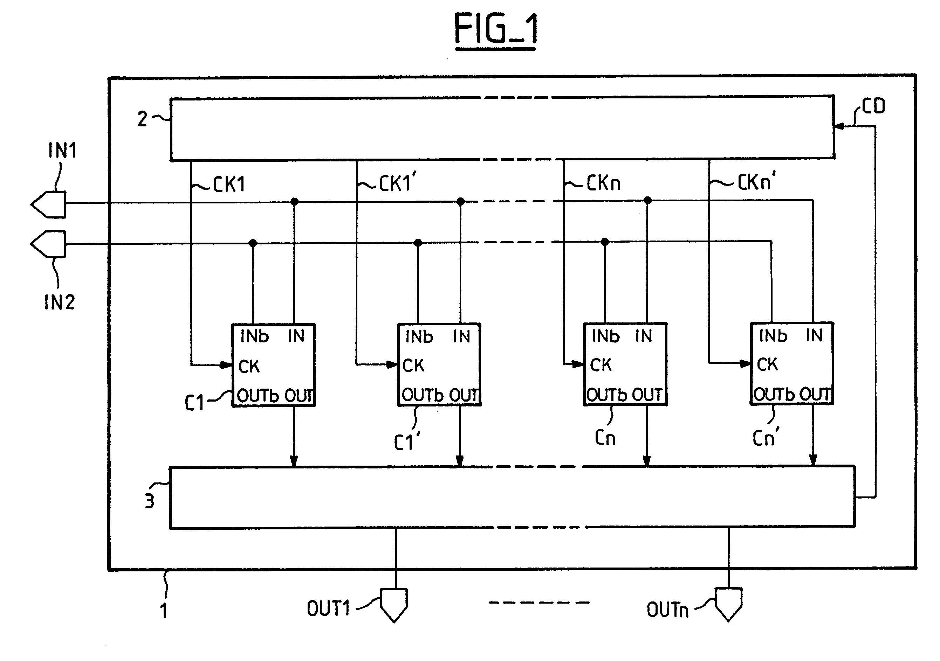

La figure 1 représente un dispositif de conversion selon l'invention capable de convertir un signal haute fréquence série de faible amplitude reçu sous forme différentielle en n signaux logiques parallèles. Ce dispositif 1 est équipé d'un circuit de traitement logique et de décision 3 et d'un circuit d'horloge programmable 2 afin de resynchroniser les signaux d'horloge du dispositif avec le signal d'horloge associé au signal d'entrée.

Le dispositif 1 comporte une entrée différentielle constituée de deux bornes d'entrée IN1 et IN2. Le signal différentiel reçu entre ces deux bornes est appliqué à l'entrée de 2n échantillonneurs/bloqueurs C1..Cn et C1'..Cn'. Tous ces échantillonneurs/bloqueurs comportent:
- deux entrées de signal IN et INb connectées respectivement aux bornes d'entrée IN1 et IN2 du dispositif de conversion,
- deux sorties de signal OUT et OUTb; la sortie OUT de chaque échantillonneur/bloqueur est connectée à une entrée du circuit de traitement logique et de décision 3; la sortie OUTb est laissée à haute impédance; et
- une entrée de commande CK pour recevoir un signal d'horloge CK1...CKn ou CK1'...CKn'.

Les signaux d'horloge sont fournis par le circuit d'horloge programmable 2. Ce circuit d'horloge est commandé par un signal de commande CD en provenance du circuit de traitement logique et de décision 3. En pratique, le circuit d'horloge 2 est composé d'une horloge, par exemple un quartz, et de 2n éléments de retard montés en série à la sortie de l'horloge. Si le signal série a une période T, on choisit une horloge de période nT et des éléments de retard introduisant au signal d'horloge un retard de T/2. Les éléments de retard vont alors délivrer des signaux d'horloge décalés les uns par rapport aux autres de T/2. Par ailleurs, le premier élément de retard est programmable. Pour retrouver les fronts du signal d'horloge associé au signal série, le signal de commande CD va agir sur l'élément de retard programmable pour avancer ou retarder les fronts des signaux d'horloge CK1...CKn et CK1'...CKn'.

Le circuit de traitement logique et de décision 3 est quant à lui une unité logique permettant de déduire à partir des échantillons obtenus à la sortie des échantillonneurs/bloqueurs si on doit avancer ou retarder les fronts des signaux d'horloge CK1...CKn et CK1'...CKn'.

Le fonctionnement de ce dispositif est le suivant: lorsqu'un signal différentiel représentant un train de bits est présent entre les bornes d'entrée IN1 et IN2, il est directement appliqué entre les entrées IN et INb des échantillonneurs/bloqueurs C1...Cn et C1'...Cn'. Le signal différentiel est alors amplifié et échantillonné deux fois par bit. On obtient alors 2n échantillons qui sont ensuite traités par le circuit 3. Le réglage du circuit d'horloge s'effectue en début de transmission. Le fonctionnement du circuit 3 va être expliqué au travers d'un exemple utilisant trois échantillons: on suppose que le premier échantillon El et le troisième échantillon E3 se rapportent respectivement à la valeur du premier et du second bit du signal différentiel et que le deuxième échantillon E2 se rapporte à la transition entre ces deux bits. Si E1=1, E2=0 et E3=0, cela veut dire que la transition se trouve entre le premier et le deuxième échantillon. Pour que E2 échantillonne au moment de la transition, il faut donc retarder les signaux d'horloge CK1...CKn et CK1'...CKn'. De la même façon, si on avait eu E1=1, E2=1 et E3=0, cela aurait voulu dire que la transition se trouvait entre le deuxième et le troisième échantillon et il aurait fallu avancer les signaux d'horloge. Ainsi, on essaie de repérer avec précision les instants de transition entre chaque bit pour déterminer les instants auxquels il faut échantillonner le signal série. Lorsqu'on traite les 20 échantillons, on obtient ainsi 10 décisions élémentaires indiquant si l'on doit avancer ou retarder les signaux d'horloge. La décision finale qui est transmise au circuit d'horloge 2 est prise à la majorité. Lorsqu'on obtient 5 décisions pour avancer et 5 décisions pour retarder, on peut estimer que la synchronisation des signaux d'horloge est achevée.

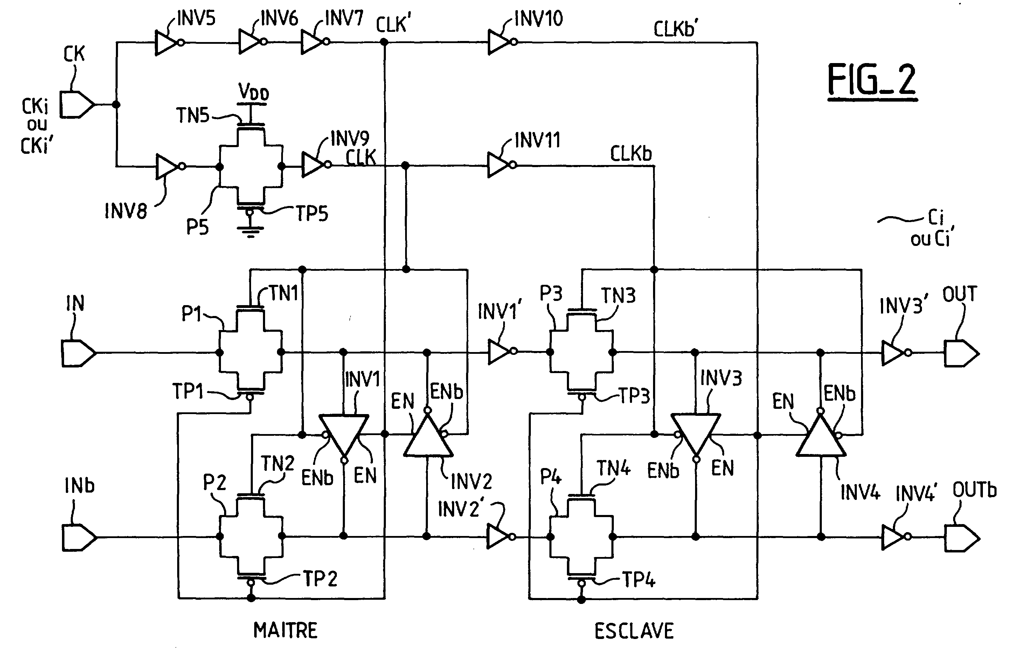

Un échantillonneur/bloqueur Ci est décrit à la figure 2. Il comprend deux cellules identiques : une cellule maître et une cellule esclave. Ces cellules reprennent la structure des points mémoire statiques. La cellule maître comporte deux inverseurs INV1 et INV2 rebouclés sur eux-mêmes. L'entrée de l'inverseur INV1 est connectée à la borne d'entrée IN par l'intermédiaire d'une porte de connexion P1, elle-même formée d'un transistor MOS de type P TP1 et d'un transistor MOS de type N TN1 montés en parallèle. De même, la sortie de l'inverseur INV1 est connectée à la borne d'entrée INb par l'intermédiaire d'une porte de connexion P2 formée de deux transistors TP2 et TN2. La cellule maître comprend par ailleurs deux inverseurs de sortie INV1' et INV2' dont les entrées sont respectivement connectées à l'entrée de l'inverseur INV1 et à l'entrée de l'inverseur INV2 et dont les sorties constituent les sorties de la cellule maître. Les inverseurs INV1' et INV2' sont utilisés pour que la sortance de la cellule maître vainque la sortance de la cellule esclave lors du transfert du contenu de la cellule maître dans la cellule esclave.

La cellule esclave reprend les éléments de la cellule maître; seules les références des éléments changent. Les éléments référencés P3, P4, INV3, INV4, INV3', INV4', TN3, TN4, TP3 et TP4 de la cellule esclave correspondent respectivement aux éléments référencés P1, P2, INV1, INV2, INV1', INV2', TN1, TN2, TP1 et TP2 de la cellule maître. Par ailleurs, pour effectuer la liaison entre les deux cellules, la sortie des inverseurs INV1' et INV2' sont reliées respectivement à l'entrée et à la sortie de l'inverseur INV3 par l'intermédiaire des porte des connexion P3 et P4. Les sorties des inverseurs INV3' et INV4' sont respectivement connectées aux bornes de sorties OUT et OUTb.

En variante, la cellule esclave pourrait se limiter à un circuit de verrouillage classique branché entre l'inverseur INV1' et la sortie OUT de l'échantillonneur/bloqueur.

De préférence, les inverseurs INV1, INV2, INV3 et INV4 comportent des entrées d'activation EN et ENb pour commander leur mise en service ou hors service.

Des signaux d'horloge sont employés pour commander l'ouverture ou la fermeture des portes de connexion P1, P2, P3 et P4 ainsi que pour commander la mise en service ou hors service des inverseurs INV1, INV2, INV3 et INV4. Tous ces signaux sont issus d'un signal d'horloge CKi fourni à l'échantillonneur/bloqueur Ci.

Le signal d'horloge CKi est traité d'une part par trois inverseurs INV5, INV6 et INV7 montés en série pour donner le signal CLK' et d'autre part par deux inverseurs INV8, INV9 et une porte de connexion P5 intercalée entre les inverseurs pour donner le signal CLK. Les signaux CLK' et CLK sont par ailleurs traités respectivement par les inverseurs INV10 et INV11 pour donner les signaux CLKb' et CLKb. La porte de connexion est composée d'un transistor TN5 de type N montée en parallèle avec un transistor TP5 de type P. La grille de commande du transistor TN5 est reliée au potentiel d'alimentation Vdd et celle du transistor TP5 est reliée au potentiel de masse Vss. Cette porte est utilisée pour que les signaux CLK et CLK' soient très précisément en opposition de phase.

Le signal d'horloge CLK est appliqué sur la grille de commande des transistors TN1 et TN2 ainsi que sur les entrées d'activation ENb des inverseurs INV1 et INV2. Le signal d'horloge CLK' est appliqué sur la grille de commande des transistors TP1 et TP2 ainsi que sur les entrées d'activation EN des inverseurs INV1 et INV2. Le signal d'horloge CLKb est appliqué sur la grille de commande des transistors TN3 et TN4 ainsi que sur les entrées d'activation ENb des inverseurs INV3 et INV4. Le signal d'horloge CLKb' est appliqué sur la grille de commande des transistors TP3 et TP4 ainsi que sur les entrées d'activation EN des inverseurs INV3 et INV4.

Cette description s'applique également aux échantillonneurs/bloqueurs Ci' commandés par les signaux d'horloge CK'i.

Le fonctionnement de ce circuit est le suivant: la cellule esclave et la cellule maître se comporte de manière identique; aussi, l'explication portera uniquement sur le fonctionnement de la cellule maître.

Deux signaux S1 et S2 formant un signal différentiel de faible amplitude et de fréquence F sont appliqués sur les entrées IN et INb et sont respectivement échantillonnés par les portes de connexion P1 et P2 à la fréquence F/n.

Pendant la phase d'échantillonnage, les portes de connexion P1 et P2 sont fermées et les inverseurs INV1 et INV2 ne sont pas activés. La cellule maître est alors équivalente à une charge capacitive pure. De préférence, les transistors formant les portes de connexion sont de taille minimale pour limiter la valeur de leur capacité et de leur résistance série. La constante de temps RC résultant du produit de la charge capacitive du point mémoire et de la résistance série des portes de connexion sera avantageusement inférieure au temps de transition entre les bits afin de garantir la transmission des signaux haute fréquence avec un minimum de distorsions.

Lorsque les portes de connexion P1 et P2 sont ouvertes, les inverseurs INV1 et INV2 sont alors mis en service. Si les valeurs V1, V2 des deux signaux S1, S2 sont comprises dans la zone de transition des inverseurs INV1 et INV2, les deux signaux vont alors être amplifiés par le point mémoire statique jusqu'à ce qu'un signal atteigne la valeur Vdd et l'autre Vss. Ainsi si au départ V1>V2, à la fin de l'amplification on aura V1=Vdd et V2=Vss.

Si les valeurs V1 et V2 des signaux S1 et S2 ne sont pas comprises dans la zone de transition des inverseurs INV1 et INV2, ces valeurs vont d'abord être amenées dans la zone de transition des inverseurs INV1 et INV2 puis la première valeur à atteindre cette zone va forcer la décision. De même, si au départ V1>V2, on obtiendra V1=Vdd et V2=Vss.

Des simulations ont démontré que, pour la conversion d'un signal série de 1 Gbps de faible amplitude en 10 signaux parallèles de 100 Mbps, la phase de 5ns allouée à l'amplification des signaux est amplement suffisante même si l'amplitude du signal différentiel est très faible et que les signaux S1 et S2 comportent un fort bruit en mode commun.

Pour le bon fonctionnement du circuit, les signaux CLK et CLK' doivent être très précisément en opposition de phase. Sinon tout décalage de phase peut alors entraîner une instabilité de la base de temps surtout lorsque les signaux différentiels sont adjoints d'une tension en mode commun. En effet, lorsque la tension en mode commun est proche de la tension d'alimentation Vdd, le transistor de type N de la porte de connexion est à basse impédance tandis que le transistor de type P est ouvert. Lorsque la tension en mode commun est proche du potentiel de masse Vss, c'est le contraire. Ainsi, si les signaux d'horloge CLK et CLK' ne commutent pas au même moment, l'instant d'échantillonnage va alors dépendre de la tension en mode commun du signal échantillonné.

## Revendications

1. Dispositif de conversion série/parallèle d'un signal série reçu sous la forme d'un signal différentiel haute fréquence de faible amplitude et de période T, lequel dispositif est destiné à convertir ledit signal série en n signaux parallèles logiques et comporte:
- une entrée série constituée d'une première borne d'entrée (IN1) et d'une seconde borne d'entrée (IN2), le signal différentiel étant reçu entre lesdites première et seconde bornes d'entrée,
- une sortie parallèle constituée de n bornes de sortie (OUT1...OUTn) pour délivrer les n signaux parallèles,
- un circuit d'horloge (2) pour délivrer n signaux d'horloge (CK1...CKn) de période nT décalés les uns par rapport aux autres d'un intervalle de temps égal à T,
- n échantillonneurs/bloqueurs (C1...Cn) pour obtenir des échantillons dudit signal série décalés les uns par rapport aux autres d'un intervalle de temps égal à T, chaque échantillonneur/bloqueur comportant une première (IN) et une seconde entrée (INb) connectées respectivement auxdites première (IN1) et seconde bornes d'entrée (IN2) du dispositif, une entrée de commande (CK) pour recevoir un desdits n signaux d'horloge (CK1...CKn), et une sortie (OUT) connectée à une des bornes de sortie (OUT1...OUTn) de la sortie parallèle pour délivrer un échantillon, chaque échantillonneur/bloqueur (C1...Cn) étant capable de réaliser simultanément une opération d'échantillonnage/blocage et une opération d'amplification des échantillons dudit signal série,
caractérisé en ce que le circuit d'horloge délivre en outre n signaux d'horloge supplémentaires (CK1'...CKn') de périodes nT, soit au total 2n signaux d'horloge de période nT qui sont décalés d'un intervalle de temps égal à T/2 les uns par rapport aux autres, et en ce qu'il est prévu en outre:
- n échantillonneurs/bloqueurs supplémentaires (C1'...Cn') pour obtenir au total 2n échantillons dudit signal série décalés d'un intervalle de temps égal à T/2,
- un circuit de traitement logique et de décision (3) pour traiter les 2n échantillons dudit signal série et déterminer si le signal série a été correctement échantillonné par rapport aux temps, lequel circuit comprend 2n entrées connectées aux sorties des 2n échantillonneurs/bloqueurs, n sorties connectées aux n bornes de sortie du dispositif et une sortie de commande délivrant un signal de commande (CD) en direction du circuit d'horloge pour décaler lesdits signaux d'horloge jusqu'à obtenir un échantillonnage correct du signal série.

2. Dispositif de conversion selon la revendication 1, caractérisé en ce que chaque échantillonneur/bloqueur (C1..Cn) comporte une partie maître pour échantillonner ledit signal série et amplifier les échantillons résultants, et une partie esclave pour mémoriser lesdits échantillons,
et en ce que la partie maître comporte une première porte de connexion (P1) connectée d'une part à la première entrée (IN) de l'échantillonneur/bloqueur et d'autre part à l'entrée d'un premier inverseur (INV1) et à la sortie d'un second inverseur (INV2), et une seconde porte de connexion (P2) connectée d'une part à la deuxième entrée (INb) de 1' échantillonneur/bloqueur et d'autre part à la sortie du premier inverseur (INV1) et à l'entrée du second inverseur (INV2), les première (P1) et deuxième (P2) portes de connexion étant commandées par un premier couple de signaux de commande (CLK, CLKb) issu dudit signal d'horloge appliquée sur l'entrée de commande de l'échantillonneur/bloqueur.

3. Dispositif de conversion selon la revendication 2 caractérisé en ce que la partie esclave comporte une troisième porte de connexion (P3) connectée d'une part à l'entrée du premier inverseur (INV1) de la partie maître et d'autre part à l'entrée d'un troisième inverseur (INV3), à la sortie d'un quatrième inverseur (INV4) et à la première sortie (OUT) de l'échantillonneur/bloqueur, une quatrième porte de connexion (P4) connectée d'une part à la sortie du premier inverseur (INV1) et d'autre part à la sortie du troisième inverseur (INV3), à l'entrée du quatrième inverseur (INV4), les troisième (P3) et quatrième (P4) portes de connexion étant commandées par un second couple de signaux de commande (CLK', CLKB') issu dudit signal d'horloge appliquée sur l'entrée de commande de l'échantillonneur/bloqueur.

4. Dispositif selon la revendication 3 caractérisé en ce que les premier (CLK, CLKb) et second (CLK', CLKb') couples de signaux de commande sont constitués de deux signaux en opposition de phase.

5. Dispositif selon la revendication 3 ou 4, caractérisé en ce que les portes de connexion (P1, P2, P3, P4) sont constituées d'un transistor de type N (TN1, TN2, TN3, TN4) dont la source et le drain sont respectivement reliés à la source et au drain d'un transistor de type P (TP1, TP2, TP3, TP4), leurs grilles de commande recevant chacune un des signaux desdits couples de signaux de commande.

6. Dispositif selon l'une des revendications précédentes caractérisé en ce qu'il est réalisé dans une technologie CMOS.

## Patentansprüche

1. Vorrichtung zur Serien-Parallel-Umwandlung eines in Form eines hochfrequenten Differenzialsignals mit niedriger Amplitude und einer Periode T empfangenen seriellen Signals, die das serielle Signal in n logische parallele Signale umwandelt und folgendes umfasst:
- einen seriellen Eingang, bestehend aus einem ersten Eingangsanschluss (IN1) und einem zweiten Eingangsanschluss (IN2), wobei das Differenzialsignal zwischen dem ersten und dem zweiten Eingangsanschluss empfangen wird,
- einen parallelen Ausgang, bestehend aus n Ausgangsanschlüssen (OUT1...OUTn) zur Lieferung der n parallelen Signale,
- eine Clock-Schaltung (2) zur Lieferung von n Clock-Signalen (CK1...CKn) mit der Periode nT, die gegeneinander um ein Zeitintervall gleich T versetzt sind,
- n Abtasthalteglieder (C1...Cn) zum Erhalt von Abtastwerten des seriellen Signals, die um ein Zeitintervall T gegeneinander versetzt sind, wobei jedes Abtasthalteglied einen mit dem ersten Eingangsanschluss (IN1) verbundenen ersten Eingang (IN) und einen mit dem zweiten Eingangsanschluss (IN2) verbundenen zweiten Eingang (INb), einen Steuereingang (CK) zum Empfangen der n Clock-Signale (CK1...CKn) sowie einen Ausgang (OUT) aufweist, der mit einem der Ausgangsanschlüsse (OUT1...OUTn) des parallelen Ausgangs verbunden ist, um einen Abtastwert zu liefern, und wobei jedes Abtasthalteglied (C1...Cn) die Abtastwerte des seriellen Signals gleichzeitig abtasten und verstärken kann,
dadurch gekennzeichnet, dass die Clock-Schaltung darüber hinaus n zusätzliche Clock-Signale (CK1'...CKn') mit Perioden nT liefert, also insgesamt 2n Clock-Signale mit der Periode nT, die um ein Zeitintervall gleich T/2 gegeneinander versetzt sind, und dadurch, dass außerdem folgendes vorgesehen ist:
- n zusätzliche Abtasthalteglieder (C1'...Cn') zum Erhalt von insgesamt 2n Abtastwerten des seriellen Signals, die um ein Zeitintervall gleich T/2 gegeneinander versetzt sind,
- eine logische Verarbeitungs- und Entscheidungsschaltung (3), um die 2n Abtastwerte des seriellen Signals zu verarbeiten und zu bestimmen, ob das serielle Signal zeitlich korrekt abgetastet wurde, wobei die Schaltung 2n mit den Ausgängen der 2n Abtasthalteglieder verbundene Eingänge, n mit den n Ausgangsanschlüssen der Vorrichtung verbundene Ausgänge sowie einen Steuerausgang umfasst, der ein Steuersignal (CD) zur Clock-Schaltung liefert, um die Clock-Signale zu versetzen, bis ein korrektes Abtasten des seriellen Signals erreicht ist.

2. Umwandlungsvorrichtung nach Anspruch 1, dadurch gekennzeichnet, dass jedes Abtasthalteglied (C1..Cn) einen Master zum Abtasten des seriellen Signals und zum Verstärken der erhaltenen Abtastwerte sowie einen Slave zum Speichern dieser Abtastwerte umfasst, und dass der Master einen ersten Anschlussport (P1), der zum einen mit dem ersten Eingang (IN) des Abtasthalteglieds und zum anderen mit dem Eingang eines ersten Inverters (INV1) und dem Ausgang eines zweiten Inverters (INV2) verbunden ist, aufweist sowie einen zweiten Anschlussport (P2), der zum einen mit dem zweiten Eingang (INb) des Abtasthalteglieds und zum anderen mit dem Ausgang des ersten Inverters (INV1) und dem Eingang des zweiten Inverters (INV2) verbunden ist, wobei der erste Anschlussport (P1) und der zweite Anschlussport (P2) von einem ersten Paar Steuersignalen (CLK, CLKb) gesteuert werden, das von dem am Steuereingang des Abtasthalteglieds angelegten Clock-Signal stammt.

3. Umwandlungsvorrichtung nach Anspruch 2, dadurch gekennzeichnet, dass der Slave am Ausgang eines vierten Inverters (INV4) und am ersten Ausgang (OUT) des Abtasthalteglieds einen zum einen mit dem Eingang des ersten Inverters (INV1) des Masters und zum anderen mit dem Eingang eines dritten Inverters (INV3) verbundenen dritten Anschlussport (P3) und am Eingang des vierten Inverters (INV4) einen vierten Anschlussport (P4) aufweist, der zum einen mit dem Ausgang des ersten Inverters (INV1) und zum anderen mit dem Ausgang des dritten Inverters (INV3) verbunden ist, wobei der dritte Anschlussport (P3) und der vierte Anschlussport (P4) von einem zweiten Paar von Steuersignalen (CLK', CLKB') aus dem am Steuereingang des Abtasthalteglieds angelegten Clock-Signals gesteuert werden.

4. Vorrichtung nach Anspruch 3, dadurch gekennzeichnet, dass das erste Paar an Steuersignalen (CLK, CLKb) und das zweite Paar an Steuersignalen (CLK', CLKb') aus zwei gegenphasigen Signalen bestehen.

5. Vorrichtung nach Anspruch 3 oder 4, dadurch gekennzeichnet, dass sich die Anschlussports (P1, P2, P3, P4) aus einem N-Transistor (TN1, TN2, TN3, TN4) zusammensetzen, dessen Source und Drain mit der Source beziehungsweise dem Drain eines P-Transistors (TP1, TP2, TP3, TP4) verbunden sind, wobei ihre Steuer-Gates jeweils eines der Signale der Paare von Steuersignalen empfangen.

6. Vorrichtung nach einem der vorhergehenden Ansprüche, dadurch gekennzeichnet, dass sie in CMOS-Technologie verwirklicht ist.

## Claims

1. Device for serial to parallel conversion of a serial signal received in the form of a high-frequency differential signal of small amplitude and period T, which device is intended to convert the said serial signal into n parallel logic signals and has:
- a serial input composed of a first input terminal (IN1) and a second input terminal (IN2), the differential signal being received between the said first and second input terminals,
- a parallel output composed of n output terminals (OUT1 ... OUTn) for delivering the n parallel signals,
- a clock circuit (2) for delivering n clock signals (CK1 ... CKn) of period nT shifted with respect to one another by a time interval equal to T,
- n sample and hold circuits (C1 ... Cn) for obtaining samples of the said serial signal shifted with respect to one another by a time interval equal to T, each sample and hold circuit having a first (IN) and a second (INb) input connected respectively to the said first (IN1) and second (IN2) input terminals of the device, a control input (CK) for receiving one of the said n clock signals (CK1 ... CKn), and an output (OUT) connected to one of the output terminals (OUT1 ... OUTn) of the parallel output for delivering a sample, each sample and hold circuit (C1 ... Cn) being capable of simultaneously carrying out a sample and hold operation and an amplification operation on the samples of the said serial signal,
characterised in that the clock circuit also delivers n additional clock signals (CK1' ... CKn') of periods nT, that is in total 2n clock signals of period nT which are shifted by a time interval equal to T/2 with respect to one another, and in that there are also provided:
- n additional sample and hold circuits (C1' ... Cn') in order to obtain in total 2n samples of the said serial signal shifted by a time interval equal to T/2,
- a logic processing and decision circuit (3) for processing the 2n samples of the said serial signal and determining whether the serial signal has been correctly sampled with respect to time, which circuit comprises 2n inputs connected to the outputs of the 2n sample and hold circuits, n outputs connected to the n output terminals of the device and a control output delivering a control signal (CD) in the direction of the clock circuit in order to shift the said clock signals until correct sampling of the serial signal is obtained.

2. Conversion device according to Claim 1, characterised in that each sample and hold circuit (C1 ... Cn) has a master part for sampling the said serial signal and amplifying the resulting samples, and a slave part for storing the said samples,
and in that the master part has a first connection gate (P1) connected on the one hand to the first input (IN) of the sample and hold circuit and on the other hand to the input of a first inverter (INV1) and to the output of a second inverter (INV2), and a second connection gate (P2) connected on the one hand to the second input (INb) of the sample and hold circuit and on the other hand to the output of the first inverter (INV1) and to the input of the second inverter (INV2), the first (P1) and second (P2) connection gates being controlled by a first pair of control signals (CLK, CLKb) issuing from the said clock signal applied to the control input of the sample and hold circuit.

3. Conversion device according to Claim 2, characterised in that the slave part has a third connection gate (P3) connected on the one hand to the input of the first inverter (INV1) of the master part and on the other hand to the input of a third inverter (INV3), to the output of a fourth inverter (INV4) and to the first output (OUT) of the sample and hold circuit, and a fourth connection gate (P4) connected on the one hand to the output of the first inverter (INV1) and on the other hand to the output of the third inverter (INV3), to the input of the fourth inverter (INV4), the third (P3) and fourth (P4) connection gates being controlled by a second pair of control signals (CLK', CLKB') issuing from the said clock signal applied to the control input of the sample and hold circuit.

4. Device according to Claim 3, characterised in that the first (CLK, CLKb) and second (CLK', CLKb') pairs of control signals are composed of two signals in phase opposition.

5. Device according to Claim 3 or 4, characterised in that the connection gates (P1, P2, P3, P4) are composed of an n-type transistor (TN1, TN2, TN3, TN4) whose source and drain are respectively connected to the source and drain of a p-type transistor (TP1, TP2, TP3, TP4), their control gates each receiving one of the signals of the said pairs of control signals.

6. Device according to one of the preceding claims, characterised in that it is implemented in CMOS technology.
